# EUROPÄISCHE PATENTSCHRIFT

(11) **EP 0 603 464 B1**
(45) Veröffentlichungstag und Bekanntmachung des Hinweises auf die Patenterteilung: **08.05.1996**
(21) Anmeldenummer: 93114012.3
(22) Anmeldetag: 02.09.1993
(51) Int. Cl.: C23C 14/32, C23C 14/34, C23C 14/54

(54) **Verfahren zum Beschichten von Substraten**
Process for coating substrates
Procédé pour le revêtement de substrats

(30) Priorität: 25.11.1992 DE 4239511
(43) Veröffentlichungstag der Anmeldung: 29.06.1994
(73) Patentinhaber: LEYBOLD AKTIENGESELLSCHAFT, D-63450 Hanau (DE)
(72) Erfinder: Zöller, Alfons, Dipl.-Ing., D-63628 Bad Soden Salmünster (DE); Schneider, Roland, Dipl.-Ing., D-63450 Hanau am Main (DE); Stoll, Helmut, Dipl.-Ing., D-65843 Sulzbach (DE); Matl, Karl, Dr., D-63801 Kleinostehim (DE)

(56) Entgegenhaltungen:
- EP-A- 0 470 777
- DD-A- 238 630
- DE-A- 4 020 158
- DE-A- 4 026 367

## Beschreibung

Die Erfindung betrifft ein Verfahren zum Beschichten von Substraten in einer Vakuumkammer mit einem in dieser angeordneten Substratträger und einer Einrichtung zur Erzeugung einer Plasmawolke und mit Magneten, die die Plasmawolke auf die Oberfläche der Substrate lenken und mit einem Elektronenstrahlverdampfer oder einem thermischen Verdampfer, von dem aus das verdampfte oder abgestäubte Material direkt auf die Substrate niedergeschlagen wird, wobei das Plasma zwischen dem Tiegel des Verdampfers und der Plasmaquelle durch Anlegen einer Potentialdifferenz zwischen der Plasmaquelle und der Vakuumkammer erzeugt wird und der Tiegel die Kathode für das Plasma bildet.

Es ist bereits ein Plasmagenerator mit Ionenstrahlerzeuger bekannt (Aufsatz von D. M. Goebel, G. Campbell und R. W. Conn im "Journal of Nuclear Material", 121 (1984), 277 - 282, North Holland Physics Publishing Division, Amsterdam), der in einer mit der Vakuumkammer verbundenen separaten Kammer angeordnet ist, wobei die etwa zylindrische Kammerwand dieser separaten Kammer die Anode bildet, und mit einem Einlaßstutzen für das Prozeßgas versehen ist.

Die zylindrische Kammer ist von ringförmigen Magnetspulen und mit Rohren zur Kühlung der Kammerwand versehen. Der Elektronen-Emitter selbst befindet sich an einem das eine Ende der zylindrischen Kammer verschließenden, dem eigentlichen Vakuumkessel abgekehrten Wandteil.

Weiterhin ist eine Kathodenzerstäubungsvorrichtung bekannt (DE-OS 38 30 478), bei der die Vakuumkammer mit einer Einrichtung zur Erzeugung eines Plasmastrahls verbunden ist und ein Target aufweist, das mit Magneten zusammenwirkt, die den Plasmastrahl auf die Oberfläche des Targets lenken, und mit einer Einrichtung versehen ist, um Ionen im Plasmastrahl zu beschleunigen, die die Oberfläche des Targets treffen und Teilchen herauslösen und Substrathalter aufweist, die im Inneren der Vakuumkammer zur Halterung der Substrate für die Beschichtung mit abgestäubten Teilchen angeordnet sind, und vorzugsweise mit einer Einrichtung, beispielsweise einer Magnetanordnung, ausgestattet ist für die Ablenkung zumindest eines Fadens oder Teilstrahls des Plasmastrahls vom Target auf das Substrat.

Darüber hinaus ist eine Vorrichtung zum Beschichten von Substraten in einer Vakuumkammer bekannt (DE 40 26 367), mit einem in dieser angeordneten Substratträger und einer Einrichtung zur Erzeugung einer Plasmawolke und mit Magneten, die die Plasmawolke auf die Oberfläche der Substrate lenken, wobei die Einrichtung zur Erzeugung der Plasmawolke einen Elektronen-Emitter mit einer nachgeschalteten rohrförmigen Anode aufweist, die mit einem Einlaß für das Prozeßgas zum Zünden des Plasmas versehen ist und die weiterhin mit Magneten ausgestattet ist zum Ausrichten und Führen des Plasmas durch das Anodenrohr in die Prozeßkammer, und mit einer in der Prozeßkammer unmittelbar neben der Plasmaquelle vorgesehenen Vorrichtung zur Erzeugung von Atomen, Molekülen oder Clustern der Materialien zur Erzeugung der Schicht auf den Substraten, vorzugsweise einem Elektronenstrahlverdampfer, von dem aus das verdampfte oder abgestäubte Material direkt auf die Substrate aufbringbar ist, wobei ein weiteres Plasma zwischen dem Tiegel des Elektronenstrahlverdampfers und dem Anodenrohr der Plasmaquelle durch Anlegen einer Potentialdifferenz zwischen der Plasmaquelle und der Vakuumkammer erzeugbar ist.

In einer älteren Patentanmeldung (P 41 28 547.6) werden ein Verfahren und eine Vorrichtung für die Herstellung einer Entspiegelungsschicht auf Linsen vorgeschlagen, wobei in einer Vakuumkammer, die einen Verdampfer und eine Plasmaquelle enthält, zuerst eine sehr dünne Haftschicht aus SiO aufgebracht wird, die dann mit einer dicken SiO₂-Schicht versehen wird, wozu der Verdampfer SiO₂-Granulat enthält und das Reaktivgas O₂ oder N₂ in die Vakuumkammer eingelassen wird und gleichzeitig mit dem Verdampfen des Materials im Verdampfer das Substrat mit dem Plasma aus der Plasmaquelle bestrahlt wird.

Schließlich ist durch die EP 0 470 777 eine Vorrichtung bekannt, bei der dem Substrat gegenüberliegend in der Prozeßkammer ein Elektronenstrahlverdampfer (von einer Blende getrennt) angeordnet ist, wobei ein Gaseinlaß in die Prozeßkammer so einmündet, daß der Gasstrahl in etwa in den Bereich zwischen dem Substrat und dem Verdampfer zum Verdampfen von inorganischen Stoffen einströmt. Diese vorbekannte Vorrichtung erlaubt neben dem Einlaß von inorganischen Stoffen auch den Einlaß von Organosiliconen (z. B. Tetraethoxysilane = TEOS) zur Erzeugung einer zweiten Schicht.

Der vorliegenden Erfindung liegt nun die Aufgabe zugrunde, durch wenige Änderungen an einer an sich bekannten APS-Quelle (Advanced Plasma Source) diese für eine PECVD-Abscheidung herzurichten. Darüber hinaus soll ein Verfahren zum Beschichten metallischer oder dielektrischer Werkstoffe mit Hilfe eines fremderzeugten Plasmas angegeben werden, mit dem die Schichthaftung, die Oberflächenspannung, die hydrophoben Eigenschaften infolge zu spröder Schicht verbessert werden kann. Schließlich soll das Verfahren das Beschichten von Substraten sowohl mit organischen als auch anorganischen Substanzen ermöglichen, ohne daß eine Unterbrechung des Prozesses notwendig wird.

Diese Aufgabe wird erfindungsgemäß durch ein Verfahren gelöst, bei dem neben den Einlaßstützen für das Prozeßgas Ar oder ein Reaktivgas ein direkt in die Prozeßkammer einmündendes, zusätzliches Gaseinleitrohr vorgesehen ist zum Einlaß kurzkettiger organischer Substanzen, beispielsweise von Hexanen oder metallhaltigen Monomeren, Metallorganika oder Siliziumorganika zum Zwecke der Kombination einer Ion Assisted Deposition (IAD) mit dem Ion Plating (IP) und dem Plasma Enhanced Chemical Vapor Deposition (PECVD).

Die Erfindung läßt die verschiedensten Ausführungsmöglichkeiten zu; eine davon ist in den anhängenden Zeichnungen schematisch näher dargestellt, und zwar zeigen:
- Figur 1: eine Vorrichtung zur Erzeugung einer PECVD-Beschichtung,
- Figur 2: eine für die Durchführung des Verfahrens geeignete Vorrichtung, die sowohl einen PVD- als auch einen PECVD-Prozeß ermöglicht und
- Figur 3: ein mit der Vorrichtung nach Figur 2 erzieltes Schichtsystem im Schnitt.

Die vorliegende Erfindung bezieht sich auf ein Verfahren zur Modifizierung von Schichteigenschaften von dünnen Schichten, die isolierend oder metallisch sein können.

Das Aufbringen solcher dünnen Schichten auf die vom Substratträger 30 gehaltenen Substrate 31, 31', ... kann sowohl durch herkömmliches Aufdampfen als auch durch ein plasmaunterstütztes Aufdampfverfahren oder im Wege eines Plasma-CVD-Prozesses in der Vakuumkammer 2 erfolgen. Das Verfahren selbst umfaßt einen plasmagestützten Prozeß, bei dem die Schichteigenschaften der aufwachsenden dünnen Schicht durch Ionenbeschuß aus einer Plasmarandschicht 32 modifizierbar sind.

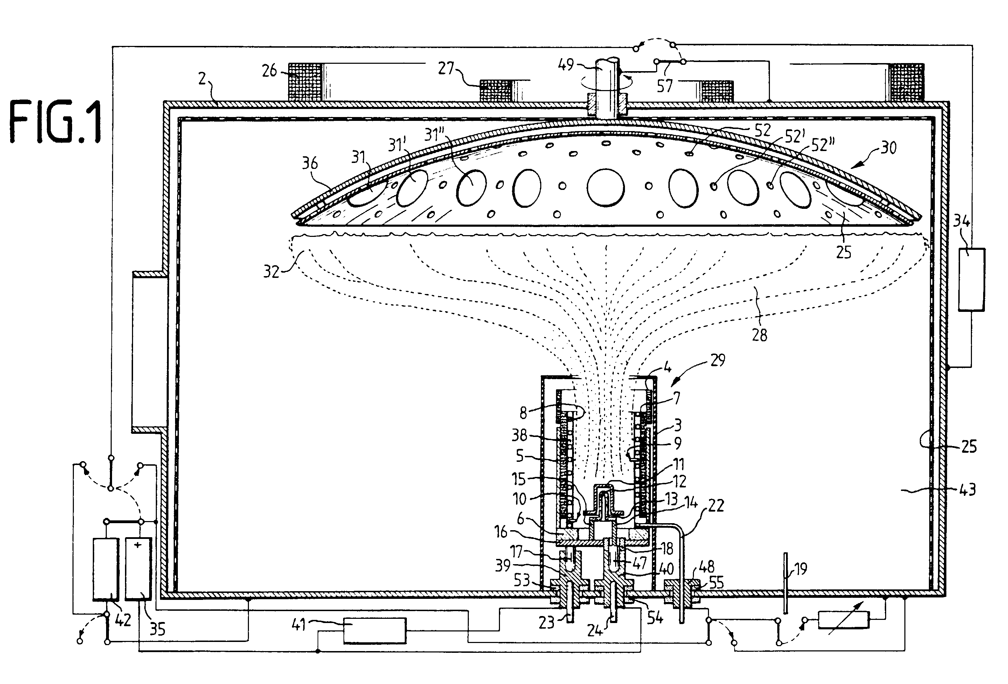

Die Vorrichtung gemäß Figur 1 umfaßt eine insgesamt mit 29 bezeichnete Plasmaquelle (APS-Quelle), in der das benötigte Plasma 28 erzeugt wird und mit Hilfe geeigneter magnetischer und elektrischer Felder aus der Quelle 29 extrahiert wird.

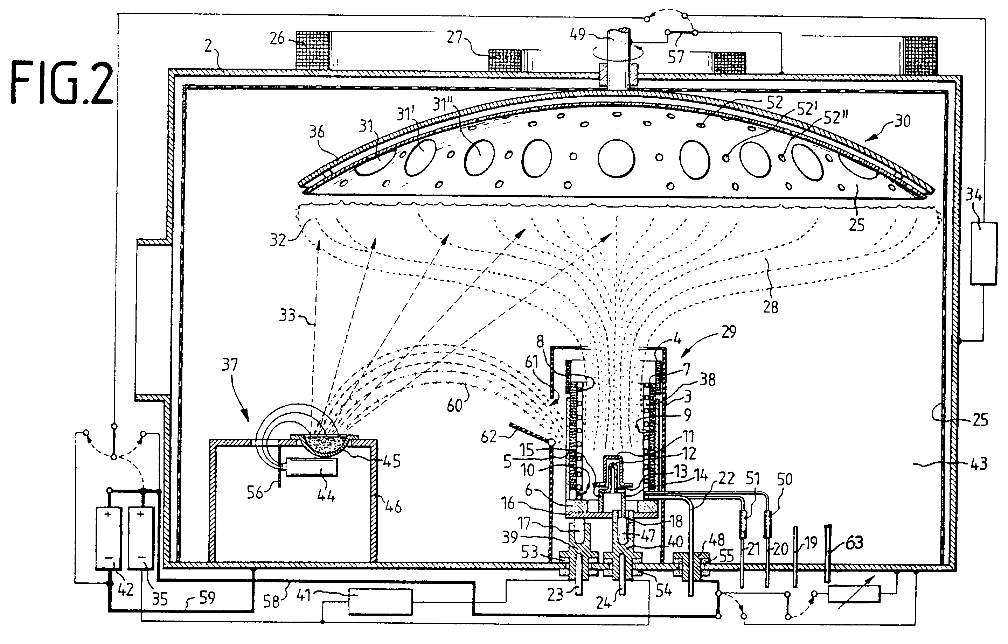

Nach der Extraktion aus der Quelle 29 wird das Plasma 28 mit Hilfe geeigneter magnetischer Felder von der Quelle 29 zum Substratträger 30 geführt, aufgeweitet und möglichst homogen auf den Bereich des Substratträgers 30 verteilt. Die Ionen des Plasmas 28 werden von Ionen der über die Leitung 19 eingeführten Gase gebildet (bzw. sind bei der Ausführungsform gemäß Figur 2 aus ionisiertem Aufdampfmaterial 33 bzw. vom Material abgespalten, das das Plasma 28 durchquert und hierbei ionisiert wird).

Der Substrathalter 30 ist entweder isoliert zur Vakuumkammer 2 oder über den Schalter 57 an ein DC- und/oder HF-Netzgerät 35, 42 bzw. 34 angeschlossen. Dieser Substrathalter 30 kann einen Bedampfungsschutz 25 aufweisen, der beim Aufbringen von isolierenden Materialien das Beschichten eines Teils der Fläche des Substratträgers 30 mit diesen isolierenden Materialien verhindert und damit ein Abfließen von elektrischen Ladungen über den Substratträger 30 ermöglicht.

Die APS-Quelle 29 gemäß Figur 2 selbst weist - zusätzlich zu den Einlässen 20, 21, 63 - einen Gaseinlaß 19 zum Einlassen von reaktiven Gasen (z. B. O₂ und N₂) auf und umfaßt ein System von elektromagnetischen Spulen 4, 7 bzw. 26, 27 zur Führung des Plasmas 28 von der Plasmaquelle 29 zum Substrathalter 30 und zur Erzeugung einer geeigneten Dichteverteilung des Plasmas am Ort des Substrathalters 30.

In der Plasmaquelle 29 wird zur Erzeugung des Plasma 28 eine heiße Glimmentladung erzeugt. Die Plasmaquelle 29 besitzt dazu eine relativ zur Anlage isolierte Kathode 11. Die Kathode 11 ist mit einem Heizer 12, beispielsweise aus Graphit, versehen, der mit einem Wechselstrom beheizt wird. Der Heizer 12 heizt indirekt über Wärmestrahlung die Kathode 11. Die Kathode 11 besteht aus einem Material, das im heißen Zustand die Emission von Elektronen ermöglicht, z. B. Lanthanhexaborid (LaB6) . Die Kathode 11 selbst besteht aus einem zylindrischen und einem deckelförmigen Teil, so daß die Emission von Elektronen sowohl in radialer als auch axialer Richtung relativ zur Achse der Quelle - im dargestellten Falle also in vertikaler Richtung - möglich ist.

Die Plasmaquelle 29 ist außerdem mit einem relativ zur Anlage und zur Kathode 11 isolierten Anodenrohr 38 versehen, das beispielsweise mit einer von Wasser durchströmten Kühlschlange 8 ausgestattet ist. Der Fluß des elektrischen Stromes erfolgt über das zur Anlage isolierte Kühlmittelrohr 22.

Das Prozeßgas selbst kann ein Edelgas sein (z. B. Ar) oder ein Reaktivgas (z. B. O₂) oder ein Gemisch von beiden, oder aber es können organische Substanzen eingelassen werden. Die Gaszuführungen 20, 21 sind von der Anlage selbst elektrisch isoliert.

Weiterhin ist die Plasmaquelle 29 mit zwei wassergekühlten Hochstromdurchführungen 39, 40 und einem langen Solenoidmagneten 7, der über das Anodenrohr 38 geschoben ist, ausgestattet, wobei dieser ein axiales Magnetfeld parallel zur vertikalen Achse der Quelle 29 erzeugt.

Mit dem Magneten 7 wird die Beweglichkeit der Elektronen in horizontaler Richtung stark erniedrigt und in vertikaler Richtung stark erhöht. Am oberen Ende des langen Solenoids 7 ist ein kurzer Solenoid 4 angeordnet, der das Magnetfeld am Ende des langen Solenoiden 7 verstärkt. Das Magnetfeld wird auf diese Weise homogener, da das axiale Magnetfeld eines Solenoiden von seiner Mitte zum Ende hin bis auf die Hälfte abnimmt.

An der Plasmaquelle 29 ist über den langen Solenoiden 7 ein zylindrisches Abschirmrohr 5 aus weichmagnetischem Material geschoben. Dieses Abschirmrohr 5 dient zum Abschirmen von Streumagnetfeldern, die sich innerhalb der Anlage befinden können, damit das Plasma 28 innerhalb der Quelle 29 nicht gestört wird. Die Plasmaquelle 29 ist darüber hinaus noch mit einer Dunkelraumabschirmung 3 versehen, die dafür Sorge trägt, daß nicht außen an der Quelle 29 unerwünschte Nebenplasmen entstehen.

Die Plasmaquelle 29 und der Substrathalter 30 sind jeweils an die Netzgeräte 34, 35, 42 anschließbar, durch das die Eigenschaften des Plasmas 28 bestimmbar sind. Außerdem ist ein besonderes Heizungsnetzgerät 41 für den Heizer 12 der Kathode 11 vorgesehen.

Weiterhin besitzt die Plasmaquelle 29 eine Stromversorgung 35 für den Entladungsstrom, mit dem die Potentialdifferenz zwischen der Kathode 11 und der Anode 38 bzw. 30 bzw. 2 festgelegt wird.

Schließlich ist die Plasmaquelle 29 mit einer Spannungsversorgung 42 versehen, die es ermöglicht, eine Bias- Potentialdifferenz beispielsweise zwischen der Plasmaquelle 29 und der Anlage 2 oder dem Substrathalter 30 anzulegen. Damit ist es möglich, das Plasmapotential und die Energie der auf die Substrate 31, 31', ... auftreffenden Ionen zu beeinflussen.

Der Substrathalter 30 ist mit einer Hochfrequenz-Spannungsversorgung 34 ausgestattet, mit der es möglich ist, auch isolierenden Substraten 31, 31', ... eine zusätzliche DC-Bias-Spannung relativ zum Plasma 28 zu bringen und damit die Energie und Stromstärke der auf die Substrate 31, 31', ... auftreffenden Ionen zu erhöhen.

Bei der dargestellten Schaltung arbeitet die Quelle als eine "Reflex-Arc"-Quelle. Das Anodenrohr 38 ist direkt mit dem Pluspol der Entladungsversorgung 35 verbunden, so daß der Entladungsstrom nur über das Anodenrohr 38 abfließen kann. Die Plasmaquelle 29 ist gegenüber den übrigen Teilen der Anlage isoliert angeordnet. Die Elektronen, die aus der Kathode 11 austreten, werden durch das axiale Magnetfeld der Solenoidmagneten 7 gehindert, direkt zum Anodenrohr 38 zu gelangen. Vielmehr folgen sie den Magnetfeldlinien und gelangen so aus der Quelle 29 heraus und erzeugen ein Plasma 28 außerhalb der Quelle. Die gesamte Quelle 29 stellt sich dazu auf ein positives Potential relativ zu den übrigen Teilen der Anlage ein, was dazu führt, daß sich ein elektrisches Feld aufbaut, das bewirkt, daß die Elektronen außerhalb der Quelle reflektiert werden und entlang der Feldlinien zum Anodenrohr 38 zurücklaufen.

Bei dieser Betriebsart lädt sich der Substrathalter 30 nicht auf ein negatives Bias-Potential auf, wie beispielsweise bei einem Ion-plating-Verfahren. Der Substrathalter 30 lädt sich typischerweise auf +2 V bis +5 V auf, wobei die Ionen ihre Energie über die Potentialdifferenz zwischen dem Anodenrohr 38 und dem Substrathalter 30 erhalten.

Typische Werte hierfür sind:
- Pₐᵣ =: 3 x 10⁻⁴ mbar durch die Quelle
- P₀₂ =: 4 x 10⁻⁴ mbar durch die Anlage
- U_{Kathode-Anode} =: 60 V
- U_{Anode-Anlage} =: +75 V
- I_{Entladung} =: 45 A

Wie aus der Zeichnung ersichtlich, ruhen sowohl das Anodenrohr 38 als auch die hohlzylindrische Magnetfeldabschirmung 5 auf der aus Keramik bestehenden Isolatorplatte 6, die ihrerseits auf der aus Kupfer bestehenden Kontaktplatte 16 abgestützt ist.

Der Heizer 12 ist mit Hilfe eines Klemmrings 13 mit dem hutförmigen Elektronen-Emitter 11 fest verbunden, wobei zwei Kontaktbolzen 14, 15 vorgesehen sind, mit denen der Heizer 12 einerseits auf der Kontaktplatte 16 und andererseits auf dem Kontaktzapfen 47 abgestützt ist.

Die Kontaktplatte 16 ist über den Zapfen 17 mit der Hochstromdurchführung 39 verbunden, die mit Hilfe des Isolators 53 an der Wand der Vakuumkammer 2 gehalten ist und der außerdem ein wasserdurchströmtes Kühlmittelrohr 23 aufweist. Die Kontaktplatte 16 ist mit Hilfe eines Keramikrings 18 gegenüber der Hochstromdurchführung 40 elektrisch isoliert, die ebenfalls mit einem Kühlmittelrohr 24 versehen ist und die über den Zapfen 47 elektrisch leitend an dem Kontaktbolzen 14 anliegt. Die Hochstromdurchführung 48 ist mit dem Isolator 55 am Bodenteil der Vakuumkammer gehalten und umschließt das wasserdurchströmte Kühlmittelrohr 22, das im übrigen mit dem DC-Netzgerät 35 verbunden ist.

Der bei der Ausführungsform gemäß Figur 2 seitlich neben der Plasmaquelle 29 am Bodenteil der Vakuumkammer 2 angeordnete Verdampfer 37 besteht aus einem Verdampfergestell 46, einem von diesem an seiner Oberseite gehaltenen Tiegel 45 mit dem zu verdampfenden Beschichtungswerkstoff, einer Elektronenstrahlkanone 44 zum Aufschmelzen und Verdampfen des Werkstoffs und einer Blende 56 für die Ausrichtung der Elektronenstrahlung.

Verwendet man also zum Aufdampfen einen Elektronenstrahlverdampfer 37, so wird das zum Aufdampfen im Tiegel 45 vorhandene Material durch den Beschuß mit Elektronen, die mit einer Elektronenstrahlkanone 44 erzeugt werden, eingeschmolzen. Hierbei werden durch den Elektronenbeschuß des zu schmelzenden Materials Sekundärelektronen erzeugt. Verwendet man in der Nähe dieses Elektronenstrahlverdampfers 37, der sich auf demselben elektrischen Potential befindet wie die Vakuumkammer 2, beispielsweise eine APS-Quelle, so kann mit Hilfe dieser Sekundärelektronen ein Plasma 28 zwischen dem Tiegel 45 des Elektronenstrahlverdampfers 37 und dem Anodenrohr 38 der APS-Quelle 29 erzeugt werden, wenn die APS-Quelle 29 und damit das Anodenrohr 38 mit Hilfe eines Bias-Netzgerätes 42 und die Leitungen 58, 59 auf ein relativ zur Anlage positives Potential gelegt wird, während gleichzeitig in der APS-Quelle 29 ein Plasma erzeugt und in die Anlage transportiert wird.

Hierzu ist es notwendig, genau gegenüber dem Elektronenstrahlverdampfer 37 eine Öffnung 61 in der Dunkelraumabschirmung 3 vorzusehen, damit die Elektronen 60, die aus dem Tiegel 45 des Elektronenstrahlverdampfers 37 austreten, auf direktem Wege zu dem Anodenpotential sich befindenden Magnetfeldabschirmrohr 5 gelangen und so das Plasma 60 erzeugen können.

Die über dem Tiegel 45 so erzeugte Plasmawolke 60 führt zu einer zusätzlichen Ionisierung des Aufdampfmaterials. Dies führt zu einer zusätzlichen Verbesserung der Schichteigenschaften der aufgebrachten dünnen Schichten und zu einer Verbesserung der Verteilung über den Substratträger, da die Ionen durch das Plasma und die in der Anlage vorhandenen magnetischen Felder auf den Substrathalter geführt werden.

Es ist klar, daß in einer besonderen Ausführungsform (nicht näher dargestellt) auch auf die Öffnung 61 verzichtet werden kann. In diesem Falle würde der Plasmastrom 60 vom Tiegel 45 aus von oben her in die obere zentrale Öffnung im Deckelteil der Dunkelraumabschirmung 3 eintreten und direkt zum Anodenrohr 38 gelangen.

In die Prozeßkammer 43 mündet schließlich noch eine zusätzliche Rohrleitung 63 (zusätzlich zu den Rohrleitungen 19, 20, 21 für das Prozeßgas Ar und für Reaktivgase, z. B. O₂, N₂) zum Einlaß kurzkettiger organischer Substanzen (Hexanen) oder von metallhaltigen Monomeren (Metallorganika, Siliziumorganika) ein.

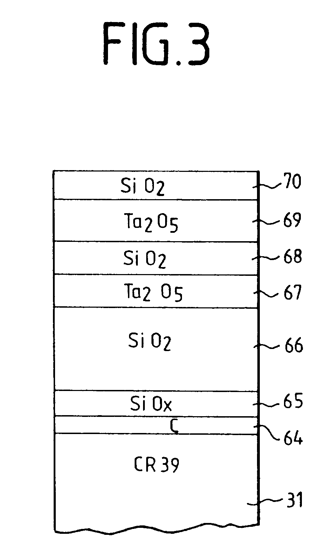

Da die verschiedenen Beschichtungsverfahren in der beschriebenen Vorrichtung (klassisches Aufdampfen, plasmaunterstütztes Aufdampfen, plasmagestützte Abscheidung aus der Gasphase, Kombination von plasmaunterstütztem Aufdampfen und plasmagestützter Gasphasenabscheidung) in beliebiger Reihenfolge und Kombination durchgeführt werden können, läßt sich (Figur 3) beispielsweise auf eine Kunststofflinse 31, 31' ...
- o eine erste: Schicht 64 aus C,
- o eine zweite: Schicht 65 aus SiO
(unterstützt durch CₓH_{y}SiO₂)
- o eine dritte: Schicht 66 aus SiO₂,
(unterstützt durch CₓH_{y}SiO₂)
- o eine vierte: Schicht 67 aus Ta₂O₅,
- o eine fünfte: Schicht 68 aus SiO₂,
- o eine sechste: Schicht 69 aus Ta₂O₅ und
- o eine siebente: Schicht 70 aus SiO2
(unterstützt durch CₓH_{y}SiO₂)
aufbringen, wobei die erste und die zweite Schicht mit dem PECVD-Verfahren, die vierte bis sechste Schicht mit dem Plasma-IAD-Verfahren und die dritte und siebente Schicht mit der Kombination aus Plasma-IAD mit PECVD-Verfahren aufbringbar sind.

Mit der in Figur 2 beschriebenen Vorrichtung sind die Vorteile des Aufdampfens (hohe Beschichtungsrate, gute Schichtdickenverteilung auch auf stark gekrümmten Substratflächen, hohe Genauigkeit und Reproduzierbarkeit der Schichtdicken, Verfügbarkeit von vielen weitestgehend erforschten Beschichtungsmaterialien und Schichtsystemen) mit den Vorteilen des PECVD (gute Haftung, Elastizität der Schichten, gewünschte Oberflächenmodifikation etc.) kombinierbar.

Der Beschichtungsprozeß mit gleichzeitigem Aufdampfprozeß erfolgt typischerweise in einem Druckbereich kleiner 10⁻³ mbar. Für Aufdampfprozesse werden in der Regel größere Distanzen zwischen Aufdampfquelle und Substrat gewählt. Dadurch ist es möglich, große Substratflächen sowie gekrümmte Substratflächen mit guter Gleichmäßigkeit zu beschichten. Die Vorrichtung gemäß Figur 2 erlaubt es, große Volumina bei geringem Druck mit Plasma auszufüllen (10 kW DC-Plasma bei ca. 1,5 x 10⁻⁴ mbar).

Das vorstehend beschriebene Verfahren eignet sich insbesondere auch
- o: um eine Verbesserung der Schichthaftung, z. B. auf PMMA, zu erzielen,
- o: zur Herstellung von Schichten mit extremen Brechungsindizes,
- o: zur Herstellung von absorbierenden Schichten, z. B. für Sonnenschutzgläser,
- o: zur Herstellung von inhomogenen Schichten und dadurch zur Erhöhung der laser-induzierten Zerstörschwellen und zur Realisierung von Rugate-Filtern (inverse Filter mit hoher Kantensteilheit) und
- o: für Barriereschichten.

Die technische Ausführung der APS-Quelle 29 erlaubt es, ein intensives Plasma mit den entsprechenden Ionenenergien im unteren bis mittleren 10⁻⁴ mbar-Bereich zu erzeugen. Hierbei ist der Bereich hoher Plasmaintensität auf den Bereich unmittelbar oberhalb der Plasmaquelle beschränkt, die Plasmadichte nimmt in Richtung des Substrathalters 30 stark ab. Eine PECVD-Beschichtung wird üblicherweise im 10⁻³ mbar-Bereich durchgeführt.

Um auch in einer Aufdampfanlage mit einem Substrathalterdurchmesser von beispielsweise 1 m effektiv PEVCD-Beschichtungen durchführen zu können, benötigt man ein intensives Plasma 28 in der gesamten Anlage, insbesondere unmittelbar vor den zu beschichtenden Substraten 30, 31', ...

Ein derartiges Plasma ist mit Argon-Gas erzeugbar. Die Modifikation der APS-Quelle gemäß Figur 1 gegenüber derjenigen nach Figur 2 besteht darin, daß sich innerhalb der Quelle kein Gaseinlaß befindet, sondern das Gas über das Rohr 19 außerhalb der Quelle 29 in die Anlage eingelassen wird. Hierbei ändert sich dramatisch die Entladecharakteristik bzw. der Plasmawiderstand.

Es ist ein intensives Argon-Plasma bei einem Druck in der Anlage von 1 x 10⁻³ mbar erzeugbar. Das Plasma füllt die gesamte Aufdampfanlage.

Hierbei stellen sich folgende Parameter ein:

| | |
|---|---|
| Entladestrom im Plasma: | 25 A |
| Potential der Anode zur Anlagenmasse: | +40 V |
| Potential der Kathode zur Anlagenmasse: | -130 V |

Mit einer in der Anlage installierten Langmuir-Sonde wurde ein Selfbias-Potential am Substrathalter von -100 V gemessen. Damit kann man erwarten, daß der Ionenbeschuß aus der Randschicht unmittelbar vor den Substraten stattfindet.

Wird nun zusätzlich zum Argon-Gas beispielsweise eine siliziumhaltige organische Substanz eingelassen (z. B. TEOS), das bekanntlich zur plasmaunterstützten Gasphasenabscheidung von SiO2 so kommt es zu einer SiO2 - Abscheidung auf den Substraten. Wird beispielsweise CH₄ zusätzlich zum Argon-Plasma eingelassen, so kommt es zu einer Abscheidung von Kohlenstoff.

### Bezugszeichenliste

- 2: Vakuumkammer
- 3: Dunkelraumabschirmung
- 4: Solenoid, Magnet
- 5: Magnetfeldabschirmung
- 6: Isolatorplatte, Keramikplatte
- 7: Magnet, Solenoid
- 8: Kühlschlange
- 9: Sauerstoffeinlaß, Einlaßstutzen
- 10: Argoneinlaß, Einlaßstutzen
- 11: Lanthanhexaborid-Kathode, Elektronen-Emitter
- 12: Graphit-Heizer
- 13: Klemmring (verschraubt mit Heizer 12)
- 14, 15: Stab, Kontaktbolzen
- 16: Kupferplatte, Kontaktplatte
- 17: Zapfen, Kontaktzapfen
- 18: Keramikring
- 19: Gaseinlaß
- 20: Sauerstoff- und/oder Stickstoffeinlaß elektrisch isoliert
- 21: Argon-Einlaß
- 22, 23, 24: wasserdurchströmtes Kühlmittelrohr
- 25: Lochblech, schirmartiger Blechzuschnitt
- 26, 27: Ringspule, Magnet
- 28: Plasmawolke
- 29: Plasmaquelle
- 30: Substrathalter, Substratträger, Anode
- 31, 31', ...: Substrat
- 32: Plasmarandschicht
- 33: Aufdampfmaterial
- 34: HF-Netzgerät, HF-Generator
- 35: DC-Netzgerät, Plasmaversorgung
- 36: Bedampfungsschutz, schirmartiger Blechzuschnitt
- 37: Elektronenstrahlverdampfer, Verdampfer
- 38: Anodenrohr
- 39, 40: Hochstromdurchführung
- 41: Stromversorgung
- 42: Spannungsversorgung (für Bias-Spannung)
- 43: Prozeßkammer
- 44: Elektronenstrahlkanone
- 45: Tiegel
- 46: Verdampfergestell
- 47: Zapfen, Kontaktzapfen
- 48: Hochstromdurchführung
- 49: Welle
- 50, 51: Isolierschlauch
- 52, 52', ...: Lochung
- 53, 54, 55: Isolator
- 56: Blende
- 57: Schalter
- 58: elektrische Leitung
- 59: elektrische Leitung
- 60: Plasmastrom, Plasmaentladung
- 61: Öffnung
- 62: Klappe, Bedampfungsschutzblende
- 63: zusätzlicher Einlaß für Hexane bzw. metallhaltige Monomere
- 64 bis 70: verschiedene Schichten

## Patentansprüche

1. Verfahren zum Beschichten von Substraten (31, 31', ...) in einer Vakuumkammer (2) mit einem in dieser angeordneten Substratträger (30) und einer Einrichtung (29) zur Erzeugung einer Plasmawolke (28) und mit Magneten (26, 27), die die Plasmawolke (28) auf die Oberfläche der Substrate (31, 31', ...) lenken, und mit einem Elektronenstrahlverdampfer (37) oder einem thermischen Verdampfer, von dem aus das verdampfte oder abgestäubte Material (33) direkt auf die Substrate (31, 31',...) niedergeschlagen wird, wobei das (Neben-)Plasma (60) zwischen dem Tiegel (45) des Verdampfers (37) und der Plasmaquelle (29) durch Anlegen einer Potentialdifferenz zwischen der Plasmaquelle (29) und der Vakuumkammer (2) erzeugt wird und der Tiegel (45) die Kathode für das Plasma bildet, und mit einer neben den Einlaßstutzen (10, 19) für das Prozeßgas Ar oder ein Reaktivgas direkt in die Prozeßkammer (43) einmündenden zusätzlichen Rohrleitung (63) zum Einlaß kurzkettiger organischer Substanzen, beispielsweise Hexane oder metallhaltige Monomere, Metallorganika oder Siliziumorganika, zum Zwecke der Kombination einer Ion Assisted Deposition (IAD) mit dem Ion Plating (IP) und dem Plasma Enhanced Chemical Vapor Deposition (PECVD).

## Claims

1. Method for coating substrates (31, 31', ...) in a vacuum chamber (2) with a substrate support (30) arranged in said vacuum chamber and a device (29) for generating a plasma cloud (28) and with magnets (26, 27) which direct the plasma cloud (28) onto the surface of the substrates (31, 31', ...) and with an electron-beam vaporiser (37) or a thermal vaporiser, from which the vaporised or sputtered material (33) is deposited directly onto the substrates (31, 31', ...), whereby the (secondary) plasma (60) between the crucible (45) of the vaporiser (37) and the plasma source (29) is generated by application of a potential difference between the plasma source (29) and the vacuum chamber (2) and the crucible (45) constitutes the cathode for the plasma, and with, besides the inlet tubes (10, 19) for the process gas Ar or a reactive gas, an additional pipeline (63) which opens directly into the process chamber (43) for the admission of short-chain organic substances, for example hexanes or monomers containing metal, organo-metals or organo-silicons for the purpose of combining Ion Assisted Deposition (IAD) with Ion Plating (IP) and Plasma Enhanced Chemical Vapour Deposition (PECVD).

## Revendications

1. Procédé pour le revêtement de substrats (31, 31', ...) dans une chambre sous vide (2) comportant un porte-substrats (30) agencé dans celle-ci et un dispositif (29) pour produire un nuage de plasma (28) et comportant des aimants (26, 27) qui guident le nuage de plasma (28) sur la surface des substrats (31, 31', ...), et comportant un vaporisateur à faisceau électronique (37) ou un vaporisateur thermique, depuis lequel le matériau vaporisé ou pulvérisé (33) est directement déposé sur les substrats (31, 31', ...), le plasma (secondaire) (60) étant produit entre le creuset (45) du vaporisateur (37) et la source de plasma (29) par application d'une différence de potentiel entre la source de plasma (29) et la chambre sous vide (2), et le creuset (45) formant la cathode pour le plasma, et ce dispositif comportant, outre le manchon d'admission (10, 19) pour le gaz de traitement Ar ou un gaz réactif, une conduite tubulaire (63) débouchant directement dans la chambre de réaction (43) pour l'admission de substances organiques à chaîne courte, par exemple des hexanes ou des monomères contenant du métal, des organo-métalliques ou des organo-siliciums, dans le but de la combinaison d'un dépôt assisté par ions (Ion Assisted Deposition (IAD)) avec un placage ionique (Ion Plating (IP)) et un dépôt chimique de vapeur renforcé par plasma (Plasma Enhanced Chemical Vapor Deposition (PECVD)).
